# EUROPEAN PATENT APPLICATION

(11) **EP 4 209 852 A1**
(43) Date of publication of application: **12.07.2023**
(21) Application number: 21863987.0
(22) Date of filing: 27.07.2021
(51) Int. Cl.: G05D 1/02

(54) **CONVEYANCE VEHICLE SYSTEM AND METHOD FOR CONTROLLING CONVEYANCE VEHICLE**

(30) Priority: 02.09.2020 JP 2020147385
(71) Applicant: Murata Machinery, Ltd., Kyoto-shi, Kyoto 601-8326 (JP)
(72) Inventor: TAKAHARA, Masayuki, Inuyama-shi, Aichi 484-8502 (JP)
(74) Representative: Hoffmann Eitle
(86) International application number: PCT/JP2021/027760
(87) International publication number: WO 2022/049929

(57) **Abstract**

[Problem] Reduction in operational rates of a device that performs processing on performed articles.

[Solution to problem] A transport vehicle system 1 includes a plurality of transport vehicles 5 and a controller 10 that allocates a transport instruction to the plurality of transport vehicles. The controller 10 allocates a first transport instruction when the first transport instruction having first priority occurs in a state in which number of vacant transport vehicles is a first number and does not allocate a second transport instruction to vacant transport vehicles when the second transport instruction having second priority lower than the first priority occurs in a state in which number of vacant transport vehicles is the first number.

## Description

### Technical Field

The present invention relates to a transport vehicle system and a method of controlling a transport vehicle.

### Background Art

A transport vehicle system that transports a goods (article) accommodating semiconductor wafers or reticles is conventionally used in a semiconductor device production facility. As an aspect, in the transport vehicle system, an article is transported to a position where a device that performs processing on an article is located. Patent Literature 1 discloses a technique to allocate a high-priority transport instruction as priority to a transport vehicle, using a transport instruction to which priority has been given.

### Citation List

### Patent Literature

Patent Literature 1: Japanese Patent No. 4705753

### Summary of the Invention

### Technical Problem

In a conventional technique, it is difficult to allocate a high-priority transport instruction when a high-priority transport instruction occurs in a state where there has no vacant transport vehicles left after a low-priority transport instruction has been allocated to a transport vehicle. That is, in the conventional technique, regardless of remaining number of vacant transport vehicles, as long as a vacant transport vehicle exists, a transport instruction is allocated once the transport instruction occurs, thus causing a state in which a high-priority transport instruction cannot be allocated. In a transport vehicle system, if a state in which a high-priority transport instruction cannot be allocated is prolonged, operational rates of a device that performs processing on transported articles are reduced.

The present invention provides a transport vehicle system capable of suppressing reduction in operational rates of a device that performs processing on transported articles and a method of controlling a transport vehicle.

### Solution to Problem

A transport vehicle system according to an aspect of the present invention includes a plurality of transport vehicles and a controller configured to allocate transport instructions to the plurality of transport vehicles. The controller is configured to allocate the first transport instruction having a first priority to a vacant transport vehicle when a first transport instruction occurs in a state where the number of vacant transport vehicles is a first number, and not to allocate a second transport instruction having a second priority lower than the first priority to a vacant transport vehicle when the second transport instruction occurs in a state where the number of vacant transport vehicles is the first number.

A method of controlling a transport vehicles according to an aspect of the present invention is a method of controlling a transport vehicle in which transport instructions are allocated to a plurality of transport vehicles, the method comprising: allocating a first transport instruction having a first priority to a vacant transport vehicle when the first transport instruction occurs in a state where the number of vacant transport vehicles is a first number; and not allocating a second transport instruction having a second priority lower than first priority to a vacant transport vehicle when the second transport instruction occurs in a state where the number of vacant transport vehicles is the first number.

### Advantageous Effects of Invention

According to a transport vehicle system and a method of controlling a transport vehicle according to an aspect of the present invention, allocation of a high-priority transport instruction is allowed and allocation of a low-priority transport instruction is not allowed in a state in which the number of vacant transport vehicles is a first number, thus enabling prevention of occurrence of a state in which a high-priority transport instruction cannot be allocated, and suppression of reduction in operational rates of a device that performs processing on transported articles.

Further, in the transport vehicle system of the aspect, a controller may be configured not to allocate the first transport instruction to a vacant transport vehicle when the first transport instruction having the first priority occurs in a state where the number of vacant transport vehicles is less than the first number. According to this aspect, in a state in which the number of vacant transport vehicles is less than the first number, even a high-priority transport instruction is not allocated, thus enabling suppression of occurrence of a state where there are not enough transport vehicles and where no vacant transport vehicle exists at a position that allows the transport instruction to be immediately allocated. Further, in the transport vehicle system of the aspect, the controller may be configured to allocate the second transport instruction to a vacant transport vehicle when the second transport instruction having the second priority occurs in a state where the number of vacant transport vehicles is a second number more than the first number. According to this aspect, in a state in which the number of vacant transport vehicles is more than the first number, allocation of a low-priority transport instruction is allowed, thus enabling suppression of occurrence of a state in which there exists no vacant transport vehicles even if a low-priority transport instruction is allocated. Further, in the transport vehicle system of the aspect, the second priority is graded into a plurality of indices of priorities sequentially lowering and the first number is graded into a plurality of indices of numbers of vacant travel vehicles sequentially increasing. The controller may be configured to allow a lower-priority transport instruction to be allocated to a vacant transport vehicle as the number of vacant transport vehicles is larger. According to this aspect, the controller allows a lower-priority transport instruction to be allocated to a vacant transport vehicle as the number of vacant transport vehicles is larger, after an index of priority and an index of the number of vacant transport vehicles are graded into a plurality. Therefore, occurrence of a state in which a higher-priority transport instruction cannot be allocated, can be suppressed while an index is flexibly changed in accordance with a scale of the system or upon request from users. Further, in the transport vehicle system of the aspect, when a top-priority transport instruction having a specific priority higher than the first priority occurs, the controller may be configured to allow the top-priority transport instruction to be allocated to the vacant transport vehicles regardless of the number of vacant transport vehicles. According to this aspect, the top transport instruction is allocated to the vacant transport vehicles regardless of the number of vacant transport vehicles. Therefore, a transport operation desired to be executed immediately can be performed promptly. Further, in the transport vehicle system of the aspect, the controller includes a plurality of area controllers, and each of the plurality of area controllers is configured to allocate a transport instruction to a transport vehicle inside a controlled area, to allocate the first transport instruction to a vacant transport vehicle when the first transport instruction occurs in a state where a total number of vacant transport vehicles inside the controlled area and vacant transport vehicles outside the controlled area is the first number, and not to allocate the second transport instruction to a vacant transport vehicle when the second transport instruction occurs in a state where the total number of vacant transport vehicles inside the controlled area and the number of vacant transport vehicles outside the controlled area is the first number. According to this aspect, the total number of vacant transport vehicles in a plurality of areas are used, thus, a transport instruction can be allocated to a vacant transport vehicle existing in a plurality of areas. Further, in the transport vehicle system of the aspect, the controller may be configured to raise priority of a transport instruction, which has not been allocated to any transport vehicle, according to passage of time since the transport instruction occurred. According to this aspect, even if priority of transport instruction is low, it is raised according to the passage of time. It can be therefore suppressed that a low-priority transport instruction remains without being allocated. Further, in the transport vehicle system of the aspect, the controller may be configured to raise priority stepwise according to the passage of time. According to this aspect, priority is raised stepwise. It can be therefore suppressed that low-priority is raised to high-priority in a short time. Further, in the transport vehicle system of the aspect, the controller is configured to allow the priority to be raised up to an upper limit, which is set to be larger as the priority upon occurrence of transport instruction is higher.

### Brief Description of Drawings

FIG.1 is a view illustrating an example of an arrangement of a transport vehicle system according to a first embodiment.
FIG.2 is a view illustrating a configuration example of a transport vehicle system according to the first embodiment.
FIG.3 is a block diagram illustrating a configuration example of a controller (area controller) according to the first embodiment.
FIG.4 is a view illustrating an information example stored in a transport vehicle information table according to the first embodiment.
FIG. 5 is a view illustrating an information example stored in a transport instruction information table according to the first embodiment.
FIG. 6 is a flowchart illustrating an example of transport vehicle control processing according to the first embodiment.
FIG. 7 is a flowchart illustrating an example of transport instruction allocation processing according to the first embodiment.
FIG. 8 is a flowchart illustrating an example of transport instruction allocation processing according to the first embodiment.
FIG. 9 is a flowchart illustrating an example of transport instruction allocation processing according to the first embodiment.
FIG. 10 is a flowchart illustrating an example of transport instruction allocation processing according to the first embodiment.
FIG. 11 is a block diagram illustrating a configuration example of controller (area controller) according to a second embodiment.
FIG. 12 is a flowchart illustrating an example of priority raising processing according to the second embodiment.

### Description of Embodiments

Hereinafter, embodiments will be described with reference to the drawings. The present invention is not limited to the embodiments described below. For detailed explanation of the embodiments, the drawings may be partially enlarged, diminished, or highlighted to change their scale where appropriate.

### [First Embodiment]

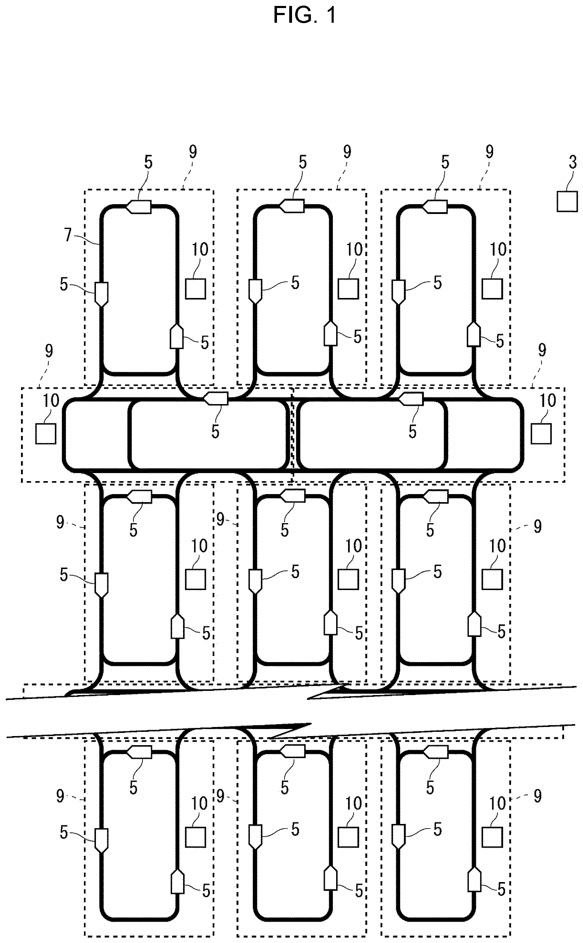

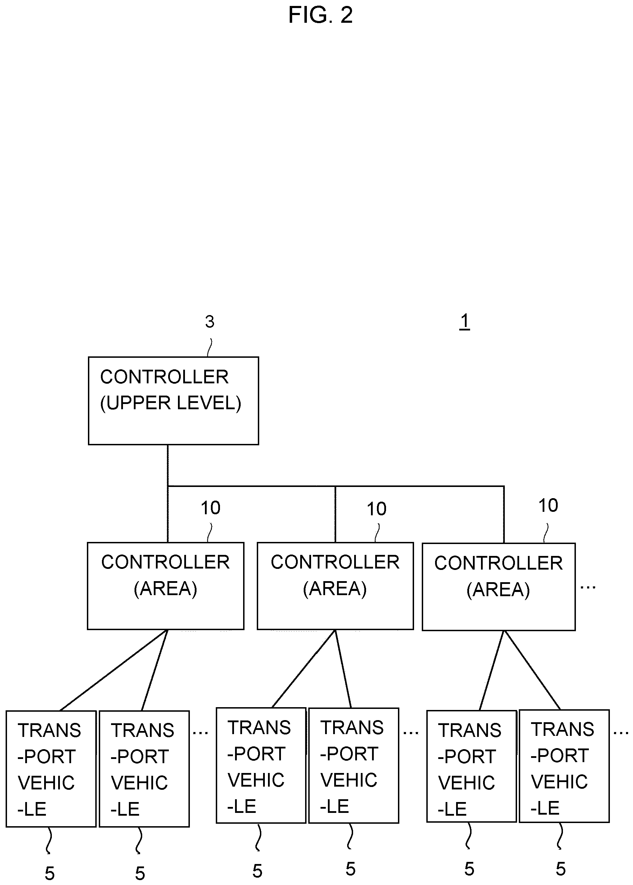

FIG.1 is a view illustrating an example of an arrangement of a transport vehicle system according to a first embodiment. FIG.2 is a view illustrating a configuration example of a transport vehicle system according to the first embodiment. The transport vehicle system 1 includes a controller 3, a plurality of transport vehicles 5, and controllers 10. For example, the transport vehicle system 1 is installed in a semiconductor device production facility and transports a container (article) such as a FOUP (Front-Opening Unified Pod) accommodating semiconductor wafers used for production of semiconductor devices or a reticle pod accommodating processing materials such as reticle.

Each of the plurality of transport vehicles 5 travels along a track 7. The track 7 is a traveling area for the plurality of transport vehicles 5. The plurality of transport vehicles 5 are overhead travel vehicles, for example. The track 7 is a traveling rail provided on a ceiling in a clean room, for example. The track 7 is provided adjacent to a processing device (not illustrated) or a stocker (no illustrated). An example of the processing device includes, for example, an exposure apparatus, a coater developer, a film formation apparatus, etching apparatus, or the like. The processing device performs various processing on semiconductor wafers contained in containers transported by the plurality of transport vehicles 5. The stocker (automated warehouse) stores containers transported by the plurality of transport vehicles 5, for example. The plurality of transport vehicles 5 may be rail-guided vehicles that travel on the ground. When the plurality of transport vehicles 5 are rail-guided vehicles that travel on the ground, the track 7 is provided on a floor. Further, the track 7 shown in the drawings is just an example and can be set optionally.

A power supply line (not illustrated) is provided on the track 7. The power supply line is arranged along the track 7. For example, alternating current is supplied to the power supply line. Each of the plurality of transport vehicles 5 includes a power receiving coil to receive power from the power supply line in a non-contact manner by electromagnetic induction. Power supply in a non-contact manner can prevent occurrence of dusts caused by contact, thus it is suitable for a clean room.

The track 7 is defined into a plurality of areas 9. A controller 10 that controls the transport vehicles 5 is arranged in each of the plurality of areas 9. The controller 10 may be referred to as "area controller". An area 9 in which the controller 10 is arranged is identified as its controlled area and the controller 10 controls the transport vehicles 5 traveling inside the controlled area. The travel vehicle 5 and the controller 10 are connected to each other so as to be able to communicate with each other by radio. Further, each of a plurality of controller 10 is connected to another controller 10 outside a controlled area over the area 9 so as to be able to communicate with each other by radio or wire.

The controller 3 outputs a transport instruction including information that instructs a loading point or an unloading point of articles. The controller 3 may be referred to as "upper-level controller". The controller 3 and each of the controllers 10 are connected to each other so as to be able to communicate with each other by radio or wire. The controller 3 which is an upper-level controller transmits a transport instruction to the controllers 10 which are lower-level controllers. Each of the controller 10 performs allocation processing of the received transport instruction and determines a transport vehicle to which an article will be transported. Whereby, the transport vehicle 5 travels toward a loading point or an unloading point of the article in accordance with the transport instruction.

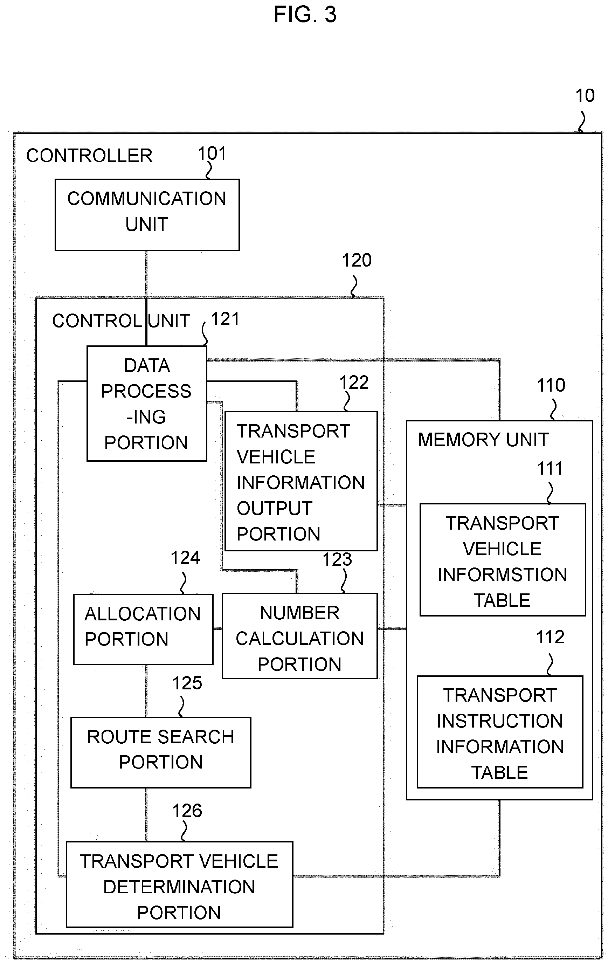

FIG.3 is a block diagram illustrating a configuration example of a controller (area controller) according to the first embodiment. Every controller 10 is of the same configuration. As shown in FIG. 3, the controller 10 has a communication unit 101, a memory unit 110, and a control unit 120. The controller 10 includes, for example, CPU (Central Processing Unit), a main memory, a storage device, a communication device, and so forth and is a computer device to execute various processing. Configuration of the computer device is optional. For example, the computer device may be constituted by a single device or by a plurality of devices.

The communication unit 101 is communicably connected to other controllers 10 or the transport vehicles 5 existing within a controlled area 9 to transmit/receive various information. The controller 10 periodically communicates with all of transport vehicles 5 existing within the controlled area 9 by polling.

The memory unit 110 includes a transport vehicle information table 111 and a transport instruction information table 112. The memory unit 110 is a non-volatile memory, for example, and stores various information received by the communication unit 101. The transport vehicle information table 111 stores information on the plurality of transport vehicles 5. Specifically, the transport vehicle information table 111 stores information on the transport vehicles 5 in an area 9 under control of the controller 10 and information on the transport vehicles 5 in an area 9 out of control of the controller 10.

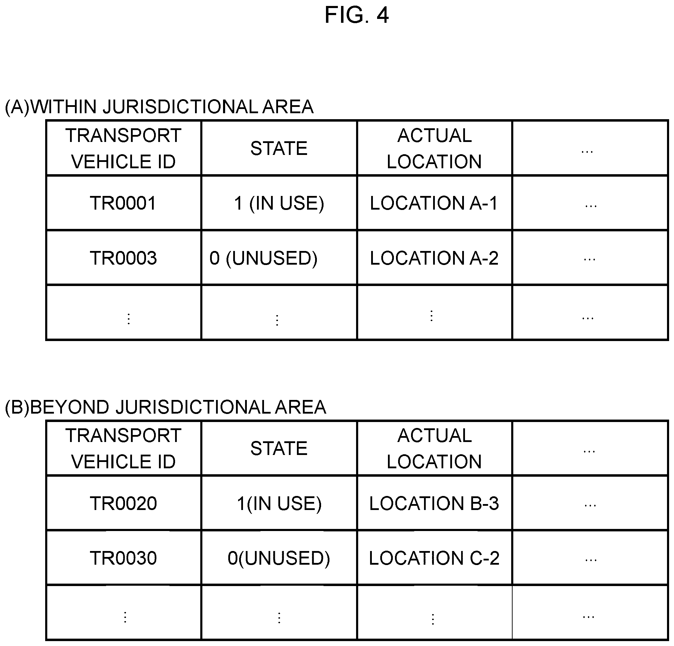

FIG.4 is a view illustrating an information example stored in a transport vehicle information table according to the first embodiment. As shown in FIG. 4, the transport vehicle information table 111 stores information : "transport vehicle ID", "status", and "actual location" for each of the transport vehicles 5 existing in area 9 under control (inside a controlled area) and in area 9 out of control (outside a controlled area),respectively, in association with each other. "Transport vehicle ID" is identification information to uniquely identify each of the plurality of transport vehicles 5. "Status" is information indicating whether or not a transport vehicle 5 is a vacant transport vehicle. Besides, "status" may include information indicating the status of the transport vehicle 5, such as whether or not the transport vehicle 5 is normal (available). For example, 1 (in use) is a flag indicating that the transport vehicle 5 is traveling on a track 7 in accordance with a transport instruction, and that the transport vehicle 5 is not a vacant transport vehicle. Further, 0(unused) is a flag indicating that a transport vehicle 5 is not traveling in accordance with a transport instruction, and that the transport vehicle 5 is a vacant transport vehicle. "Actual location" is information indicating an actual location of the transport vehicle 5 in a traveling area. With reference to the transport vehicle information table 111, the controller 10 can recognize the number of vacant transport vehicles existing in the area 9 under control, the number of vacant transport vehicles existing in the area 9 out of control, and the number of vacant transport vehicles existing in a plurality of areas 9.

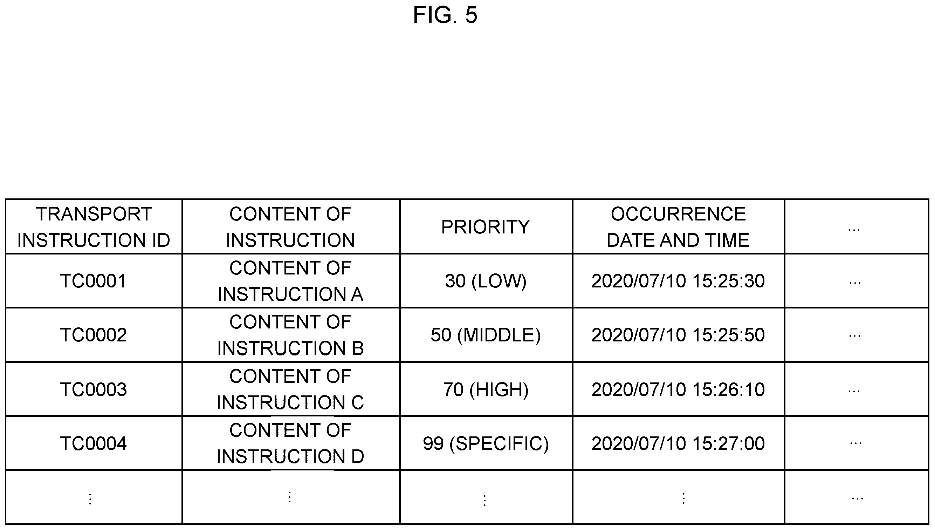

The transport instruction information table 112 stores information on a transport instruction. FIG. 5 is a view illustrating an information example stored in a transport instruction information table according to the first embodiment. As shown in FIG. 5, the transport instruction information table 112 stores information of "transport instruction ID", "content of instruction", "priority", and "occurrence date and time" in association with each other. "Transport instruction ID" is identification information to uniquely identify each transport instruction. "Content of instruction" includes information on a loading point (from) or an unloading point (to). "Priority" is information indicating a level of priority of a transport instruction. It is preferable that the higher the priority is, the earlier the transport instruction is executed. As an example, the higher the priority is, the larger value the value of priority is presented by. In the present embodiment, the value of the priority less than 40 is defined as "low", the value of the priority equal to or more than 40 and less than 60 is defined as "middle", the value of the priority equal to or more than 60 is defined as "high", and the value of the priority equal to 99 is defined as "specific" (specific priority).

For example, a transport instruction having "low" priority corresponds to a transport instruction from a stocker to a stocker. For example, a transport instruction having a "middle" priority corresponding to a transport instruction from a stocker to a processing device. For example, a transport instruction having a "high" priority corresponds to a transport instruction from a processing device to a stocker. That is, in the present embodiment, it is one of the aims that a reduction in operation of a processing device is suppressed by prioritizing a transport to a processing device or a transport from a processing device. Further, it is possible to allocate a transport instruction having "specific" priority (specific-priority) not only to a vacant vehicle but also to a transport vehicle 5 being executing another transport instruction. Division of priority is not limited thereto. Any scope, any value, and any number of divisions can be set. Occurrence date and time is information indicating date and time when a transport instruction occurs. Date and time when a transport instruction occurs may be consistent with either the timing when a transport instruction is transmitted by the controller 3 or the timing when a transport instruction is received by the controller 10.

The control unit 120 includes a data processing portion 121, a transport vehicle information output portion 122, a number calculation portion 123, an allocation portion 124, a route search portion 125, and a transport vehicle determination portion 126. The data processing portion 121 performs processing of various information received by the communication unit 101 and processing of various information transmitted by the communication unit 101. Specifically, the data processing portion 121 stores various information (e.g. transport vehicle information or transport instruction information) received by the communication unit 101 into the memory unit 110. Further, when a transport instruction information is received by the communication unit 101, the data processing portion 121 may inform the number calculation portion 123 of the receipt. Further, the data processing portion 121 receives various information (e.g. transport vehicle information or a transport instruction) from the transport vehicle information output portion 122 or the transport vehicle determination portion 126 and controls transmission of various information performed by the communication unit 101.

The transport vehicle information output portion 122 outputs information of transport vehicles existing in the controlled area 9 of the controller 10 (itself). The transport vehicle information output portion 122 periodically outputs the transport vehicle information. Specifically, the transport vehicle information output portion 122 obtains the transport vehicle information of its controlled area 9 from the transport vehicle information table 111(see FIG. 4(A)) and outputs it to the data processing portion 121. When the transport vehicle information is received from the transport vehicle output portion 122, the data processing portion 121 controls transmission of the transport vehicle information to other controllers 10 located in areas 9 out of control via the communication unit 101. When the transport vehicle information is received, other controllers 10 stores the received transport vehicle information into the transport vehicle information table 111 (see FIG. 4(B)) as transport vehicle information of areas 9 out of control. That is, in response to a receipt of the transport vehicle information via the communication unit 101, the data processing portion 121 stores it into the transport vehicle information table 111 as transport vehicle information of areas 9 out of control. Further, the data processing portion 121 periodically receives the transport vehicle information from transport vehicles 5 existing in areas 9 under control via the communication unit 101 and stores it into the transport vehicle information table 111 (see FIG. 4 (A)).

The number calculation portion 123 calculates the number of vacant transport vehicles. Specifically, with reference to the transport vehicle information table 111, the number calculation portion 123 calculates the number of data indicating that "state" is "0(unused)" (corresponding to vacant transport vehicle). The number calculation portion 123 identifies the sum of the number of data of areas 9 under control and the number of data of areas 9 out of control as the number of vacant transport vehicles. That is, the number of vacant transport vehicles is the total number of vacant transport vehicles existing in each of a plurality of areas 9. The number calculation portion 123 may calculate the number of vacant transport vehicles in a periodic manner or in the timing when the data processing portion 121 receives a transport instruction.

The allocation portion 124 determines allocation of a transport instruction, using the transport instruction information table 112. Specifically, when a first transport instruction having a first priority occurs in a state in which the number of vacant transport vehicles calculated by the number calculation portion 123 is the first number, the allocation portion 124 determines to allocate the first transport instruction to a vacant transport vehicle with reference to the transport instruction information table 112. Further, when a second transport instruction having a second priority lower than the first priority occurs in a state in which the number of vacant transport vehicles calculated by the number calculation portion 123 is the first number, the allocation portion 124 determines not to allocate the second transport instruction to a vacant transport vehicle with reference to the transport instruction information table 112. The first number is not an index indicating a predetermined number but an index having a range, for example, equal to or more than X and less than Y. That is, when the first transport instruction having the first priority and the second transport instruction having the second priority lower than the first priority occur in a state in which the number of vacant transport vehicles is the first number (equal to or more than X and less than Y), the allocation portion 124 determines to allocate only the first transport instruction to a vacant transport vehicle. When transport instructions having the same priority occur, the allocation portion 124 determines to allocate a transport instruction having a larger value of priority. If the values of priority are the same, the allocation portion 124 determines to allocate a transport instruction the occurrence date and time of which is earlier.

When the first transport instruction having the first priority occurs in a state in which the number of vacant transport vehicles calculated by the number calculation portion 123 is less than the first number, the allocation portion 124 determines not to allocate the first transport instruction to a vacant transport vehicle with reference to the transport instruction information table 112. That is, when the number of vacant transport vehicles is less than the first number (less than X), the allocation portion 124 determines not to allocate even the first transport instruction having the first priority to a vacant transport vehicle.

When a second transport instruction having the second priority occurs in a state in which the number of vacant transport vehicles calculated by the number calculation portion 123 is a second number more than the first number, the allocation portion 124 determines to allocate the second transport instruction to a vacant transport vehicle with reference to the transport instruction information table 112. That is, when the number of vacant transport vehicles is the second number (equal to or more than Y), the allocation portion 124 determines to allocate even the second transport instruction having the second priority to a vacant transport vehicle.

In the present embodiment, the first number is graded into a plurality of indices of numbers of vacant transport vehicles sequentially increasing. The second priority is graded into a plurality of indices of priorities sequentially lowering. That is, the location portion 124 allows a transport instruction having the lower-priority to be allocated to a vacant transport vehicle as the number of vacant transport vehicles is larger.

Further, when a top-priority transport instruction having specific priority higher than the first priority occurs, the allocation portion 124 allows the top-priority transport instruction to be allocated to the vacant transport vehicles regardless of the number of vacant transport vehicles with reference to the transport instruction information table 112. That is, when the top-priority transport instruction having specific priority occurs, the allocation portion 124 allows the top-priority transport instruction to be allocated to the vacant transport vehicles in spite of any of a state in which the number of vacant transport vehicles is less than the first number (less than X), a state in which the number of vacant transport vehicles is the first number (equal to or more than X and less than Y), and a state in which the number of vacant transport vehicles is the second number (more than Y). As described above, the top-priority transport instruction having specific priority can be allocated not only to a vacant transport vehicle but also a transport vehicle 5 being executing another transport instruction. Before the number calculation portion 123 calculates the number of the vacant transport vehicles, the allocation portion 124 checks the presence or absence of the top-priority transport instruction having specific priority with reference to the transport instruction information table 112. When there exists the top-priority transport instruction having specific priority, the allocation portion 124 may determine allocation of the top-priority transport instruction. In another way, the allocation portion 124 receives information that the top-priority transport instruction having specific priority has been received, from the data processing portion 121, and then may determine allocation of the top-priority transport instruction. That is, when the top-priority transport instruction having specific priority occurs, allocation of the top-priority transport instruction may be determined without a calculation of the number of vacant transport vehicles performed by the number calculation portion 123. As described above, even the first transport instruction having the first priority is not allocated in a state in which the number of vacant transport vehicles is less than the first number. One of the reasons to do so is to allocate the top-priority transport instruction immediately when the top-priority transport instruction having specific priority which is further higher priority occurs.

The route search portion 125 sets a traveling route according to a transport instruction. Specifically, the route search portion 125 sets a traveling route of a transport vehicle 5 based on the transport instruction determined to be allocated by the allocation portion 124 and map information of the transport vehicle system 1. If a route search is performed in the side of a transport vehicle 5 in the system, the route search performed by the route search portion 125 may be omitted.

The transport vehicle determination portion 126 determines a transport vehicle 5 that will execute a transport instruction. Specifically, with reference to the transport vehicle information table 111, the transport vehicle determination portion 126 determines a transport vehicle 5 that will execute the transport instruction determined to be allocated by the allocation portion 124. For example, the transport vehicle determination portion 126 determines a transport vehicle 5 (vacant transport vehicle) a state stored in the transport vehicle information table 111 of which is "0(unused)" as a transport vehicle 5 that will execute the transport instruction. If there exists no vacant transport vehicle in the controlled area 9, the transport vehicle determination portion 126 determines a vacant transport vehicle existing in area 9 out of control as a transport vehicle 5 that will executes the transport instruction. Preferably, the transport vehicle determination portion 126 adopts a vacant transport vehicle existing in an area 9 out of control closer to the controlled area 9 based on an actual location. Determining a vacant transport vehicle existing in a place closer to the controlled area 9 as a transport vehicle 5 that will execute the transport instruction can improve transport efficiency. Further, when a transport instruction determined to be allocated by the allocation portion 124 is a top-priority transport instruction having specific priority, the transport vehicle determination portion 126 may determine a vacant transport vehicle as a transport vehicle that will execute a transport instruction or may determine a transport vehicle 5 being executing another transport instruction as a transport vehicle that will execute a transport instruction. It is preferable that the transport vehicle determination portion 126 determines a transport vehicle 5 being executing another transport instruction as a transport vehicle that will execute a transport instruction when there exists no vacant transport vehicles. Then, the transport vehicle determination portion 126 instructs the data processing portion 121 to transmit the transport instruction and a traveling route set by the route search portion 125 to the transport vehicle 5 that will execute the transport instruction. Whereby, the data processing portion 121 controls a transmission of the transport instruction or the like to the transport vehicle 5 via the communication unit 101.

After the transport instruction or the like is transmitted to the transport vehicle 5, the controller 10 updates information stored in the transport instruction information table 112. Specifically, the controller 10 removes information corresponding to the transport instruction transmitted to the transport vehicle 5 from the transport instruction information table 112, or the controller 10 may provide a flag (indicating that a transport instruction has been completed) on the transport instruction information table 112 with respect to information corresponding to the transport instruction transmitted to the transport vehicle 5. The controller 10 may remove information for which a flag has been provided to indicate that the transport instruction had been completed from the transport instruction information table 112 at any timing. The controller 10 receives transport vehicle information from transport vehicles 5 or other controllers 10, therefore the controller 10 need not update information stored in the transport vehicle information table 111 at a timing after the transport instruction or the like transmits to transport vehicle 5.

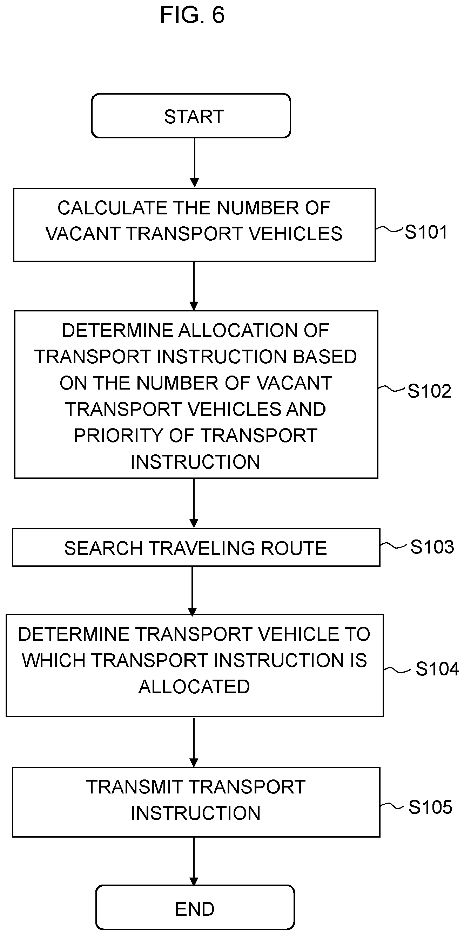

FIG. 6 is a flowchart illustrating an example of transport vehicle control processing according to the first embodiment. As shown in FIG. 6, the number calculation portion 123 calculates the number of vacant transport vehicles (step S101). Specifically, with reference to the transport vehicle information table 111, the number calculation portion 123 calculates the number of data indicating that a state is "0(unused). The number calculation portion 123 identifies the sum of the number of data of areas 9 under control and the number of data of areas 9 out of control as the number of vacant transport vehicles.

The allocation portion 124 determines allocation of a transport instruction based on the number of vacant transport vehicles and priority of a transport instruction (step S102). Specifically, according to the number of vacant transport vehicles calculated by the number calculation portion 123 and priority of the transport instruction stored in the transport instruction information table 112, the larger the number of vacant transport vehicles is, the allocation portion 124 allows a lower-priority transport instruction to be allocated to the vacant transport vehicles. The detail of processing performed in step S102 will be described later.

The route search portion 125 searches a traveling route (step S103). Specifically, the route search portion 125 sets a traveling route for a transport vehicle 5 based on a transport instruction determined to be allocated by the allocation portion 124, map information of the transport vehicle system 1, and so forth. The transport vehicle determination portion 126 determines a transport vehicle to which a transport instruction is allocated (step S104). Specifically, with reference to the transport vehicle information table 111, the transport vehicle determination portion 126 determines a transport vehicle 5 that will execute the transport instruction determined to be allocated by the allocation portion 124. The data processing portion 121 transmits the transport instruction (step S105). Specifically, the data processing portion 121 controls transmission of the transport instruction or the like to the transport vehicle 5 determined by the transport vehicle determination portion 126 via the communication unit 101.

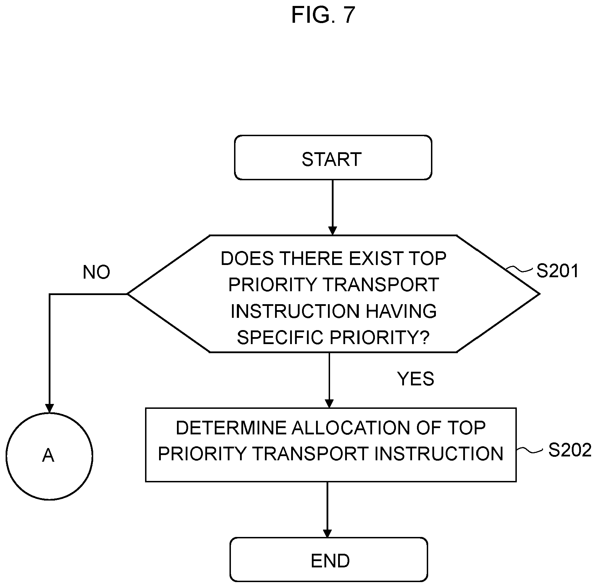

FIGS. 7 to 10 are flowcharts illustrating an example of transport instruction allocation processing according to the first embodiment. FIGS. 7 to 10 show details of processing performed in step S102. In the description of FIGS. 7 to 10, an index of the number of vacant transport vehicles is divided into "less than the first number" (less than X), "the first number"(equal to or more than X and less than Y), "the second number"(equal to or more than Y and less than Z), and "equal to or more than the second number (equal to or more than Z), and an index of priority is divided into a specific priority, a first priority, a second priority, and a third priority(the specific priority > the first priority> the second priority> the third priority). X, Y, and Z are natural numbers that satisfy X<Y<Z.

As shown in FIG. 7, the allocation portion 124 determines whether or not there exists a top-priority transport instruction having specific priority (step S201). Specifically, with reference to the transport instruction information table 112, the allocation portion 124 determines whether or not there exists a top-priority transport instruction having specific priority"99 (specific)". When there exists a top-priority transport instruction having specific priority (step S201: YES), the allocation portion 124 determines allocation of the top-priority transport instruction (step S202). Specifically, when there exists a top-priority transport instruction having specific priority "99" in the transport instruction information table 112, the allocation 124 determines allocation of the top-priority transport instruction to a transport vehicle 5. On the other hand, when there exists no top-priority transport instruction having specific priority (step S201: NO), the process goes to flow "A"

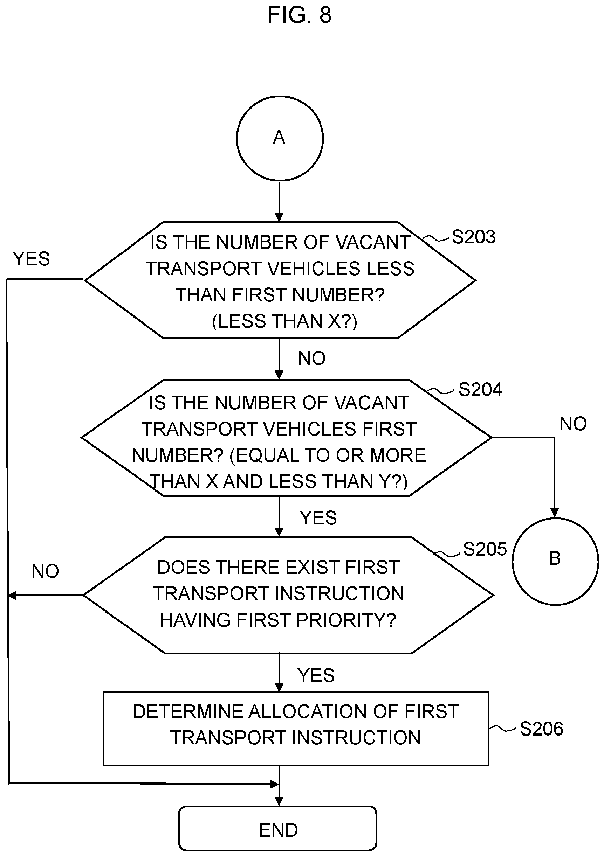

As shown in FIG. 8, the allocation portion 124 determines whether or not the number of vacant transport vehicles is less than the first number (step S203). Specifically, the allocation portion 124 determines whether or not the number of vacant transport vehicles calculated by the number calculation portion 123 is less than the first numberless than X). When the number of vacant transport vehicles is less than the first number (step S203: YES), the allocation portion 124 completes the processing without determining any allocation of transport instruction. Specifically, the number of vacant transport vehicles is less than the first number (less than X) and there exists a very small number of vacant transport vehicles (or no vacant transport vehicles), thereby, the allocation portion 124 does not allocate the first transport instruction having the first priority, the second transport instruction having the second priority, and the third transport instruction having the third priority.

On the other hand, when the number of vacant transport vehicles is not less than the first number (step S203: NO), the allocation portion 124 determines whether or not the number of vacant transport vehicles is the first number (step S204). Specifically, when the number of vacant transport vehicles calculated by the number calculation portion 123 is not less than the first number (less than X) , the allocation portion 124 determines whether or not the number of vacant transport vehicles is the first number (equal to or more than X and less than Y). When the number of vacant transport vehicles is the first number (step S204: YES), the allocation portion124 determines whether or not there exists the first transport instruction having the first priority (step S205). Specifically, when the number of vacant transport vehicles calculated by the number calculation portion 123 is the first number (equal to or more than X and less than Y), the allocation portion 124 determines whether or not there exists the first transport instruction having the first priority "high" with reference to the transport instruction information table 112. On the other hand, when the number of vacant transport vehicles is not the first number (step S204: NO), the process goes to flow "B".

When there exists the first transport instruction having the first priority (step S205: YES), the allocation portion124 determines allocation of the first transport instruction (step S206). Specifically, when the first transport instruction having the first priority "high" is stored in the transport instruction information table 112, the allocation portion 124 determines to allocate the first transport instruction to a vacant transport vehicle. When a plurality of the first transport instructions having the first priority "high" are stored in the transport instruction information table 112, the allocation portion 124 determines to allocate the first transport instruction having a larger value of priority to a vacant transport vehicle. When values of priority are the same, the allocation portion 124 determines to allocate the first transport instruction occurrence date and time of which are earlier to a vacant transport vehicle. On the other hand, when there exists no first transport instruction having the first priority (step 205: NO), the allocation portion 124 completes the processing without determining allocation of any transport instruction. Specifically, since there exists no transport instruction (first transport instruction) capable of being allocated when the number of vacant transport vehicles is the first number (equal to or more than X and less than Y), the allocation portion 124 completes the processing without determining any allocation of transport instruction.

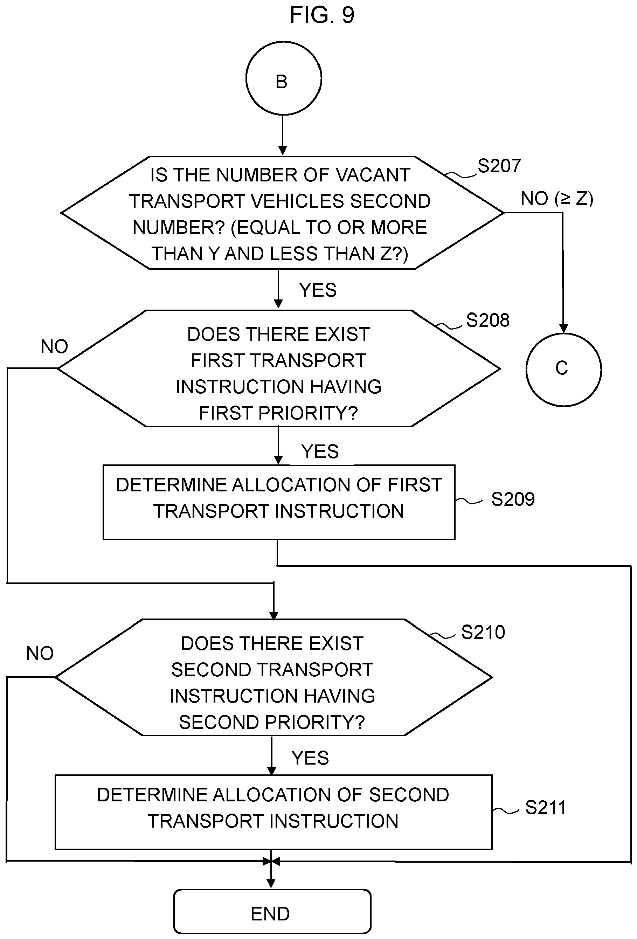

As shown in FIG. 9, the allocation portion 124 determines whether or not the number of vacant transport vehicles is the second number (step: S207). Specifically, the allocation portion 124 determines whether or not the number of vacant transport vehicles calculated by the number calculation portion 123 is the second number (equal to or more than Y and less than Z). When the number of vacant transport vehicle is not the second number (step S207: NO), the allocation portion 124 executes flow "C". Specifically, the number of vacant transport vehicles calculated by the number calculation portion 123 is equal to or mother than the second number (equal to or more than Z), the allocation portion 124 executes flow "C".

On the other hand, when the number of vacant transport vehicles is the second number (step S207: YES), the allocation portion 124 determines whether or not there exists the first transport instruction having the first priority (step S208). Specifically, when the number of vacant transport vehicles calculated by the number calculation portion 123 is the second number (equal to or more than Y and less than Z), the allocation portion 124 determines whether or not there exists the first transport instruction having a first priority "high" with reference to the transport instruction information table 112. When there exists the first transport instruction having the first priority (step S208: YES), the allocation portion 124 determines allocation of the first transport instruction (step S209).Specifically, when the first transport instruction having the first priority "high" is stored in the transport instruction information table 112, the allocation portion 124 determines to allocate the first transport instruction to a vacant transport vehicle. When a plurality of first transport instruction having the first priority "high", are stored in the transport instruction information table 112, the allocation portion 124 determines to allocate the first transport instruction having a larger value of priority to a vacant transport vehicle. When values of priority are the same, the allocation portion 124 determines to allocate the first transport instruction occurrence date and time of which are earlier to a vacant transport vehicle.

When there exist no first transport instruction having the first priority (step S208: NO), the allocation portion 124 determines whether or not there exists a second transport instruction having a second priority (step S210). Specifically, when the first transport instruction having the first priority "high" is not stored in the transport instruction information table 112, the allocation portion 124 determines whether or not the second transport instruction having the second priority "middle" is stored in the transport instruction information table 112. When there exists the second transport instruction having the second priority (step S210: YES), the allocation portion 124 determines allocation of the second transport instruction (step S211). Specifically, when the second transport instruction having the second priority "middle" is stored in the transport instruction information table 112, the allocation portion 124 determines to allocate the second transport instruction to a vacant transport vehicle. When a plurality of second transport instructions having the second priority "middle" are stored in the transport instruction information table 112, the allocation portion 124 determines to allocate the second transport instruction having a larger value of priority to a vacant transport vehicle. When values of priority are the same, the allocation portion 124 determines to allocate the second transport instruction occurrence date and time of which are earlier to a vacant transport vehicle.

On the other hand, when there exists no second transport instruction having the second priority (step S210: NO), the allocation portion 124 completes the processing without determining any allocation of a transport instruction. Specifically, since there exists no transport instruction (first transport instruction and second transport instruction) capable of being allocated when the number of vacant transport vehicles is the second number (equal to or more than Y and less than Z), the allocation portion 124 completes processing without determining any allocation of a transport instruction.

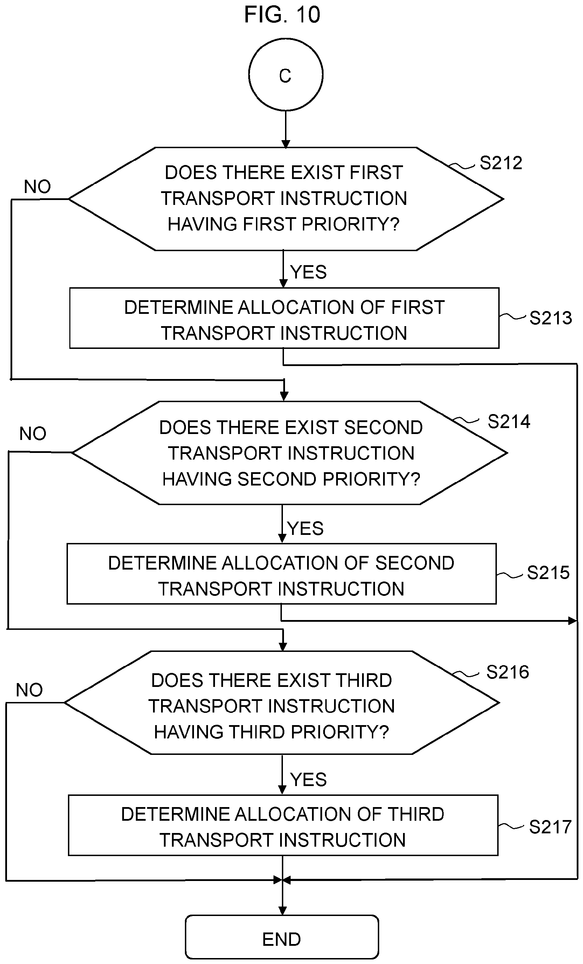

As described above, FIG. 10 is a flowchart when the number of vacant transport vehicles is equal to or more than the second number (equal to or more than Z). As shown in FIG. 10, the allocation portion 124 determines whether or not there exists a first transport instruction having the first priority (step S212). Specifically, when the number of vacant transport vehicles calculated by the number calculation portion 123 is equal to or more than the second number (equal to or more than Z), the allocation portion 124 determines whether or not there exists the first transport instruction having the first priority "high". When there exists first transport instruction having the first priority (step S212: YES), the allocation portion 124 determines allocation of the first transport instruction (step S213). Specifically, when the first transport instruction having the first priority "high" is stored in the transport instruction information table 112, the allocation portion 124 determines to allocate the first transport instruction to a vacant transport vehicle. When a plurality of first transport instructions having the first priority "high" are stored in the transport instruction information table 112, the allocation portion 124 determines to allocate the first transport instruction having a larger value of priority to a vacant transport vehicle. When values of priority are the same, the allocation portion 124 determines to allocate the first transport instruction occurrence date and time of which are earlier to a vacant transport vehicle.

On the other hand, when there exists no first transport instruction having the first priority (step S212: NO), the allocation portion 124 determines whether or not there exists a second transport instruction having the second priority (step S214). Specifically, when the first transport instruction having the first priority "high" is not stored in the transport instruction information table 112, the allocation portion 124 determines whether or not a second transport instruction having the second priority "middle" is stored in the transport instruction information table 112. When there exists the second transport instruction having the second priority (step S214: YES), the allocation portion 124 determines allocation of the second transport instruction (step S215). Specifically, when the second transport instruction having the second priority "middle" is stored in the transport instruction information table 112, the allocation portion 124 determines to allocate the second transport instruction to a vacant transport vehicle. When a plurality of second transport instructions having the second priority "middle" are stored in the transport instruction information table 112, the allocation portion 124 determines to allocate the second transport instruction having a larger value of priority to a vacant transport vehicle. When values of priority are the same, the allocation portion 124 determines to allocate the second transport instruction occurrence date and time of which are earlier to a vacant transport vehicle.

On the other hand, when there exists no second transport instruction having the second priority (step S214: NO), the allocation portion 124 determines whether or not there exists a third transport instruction having the third priority (step S216). Specifically, when the second transport instruction having the second priority "middle" is not stored in the transport instruction information table 112, the allocation portion 124 determines whether or not the third transport instruction having the third priority "low" is stored in the transport instruction information table 112. When there exists the third transport instruction having the third priority (step S216: YES), the allocation portion 124 determines allocation of the third transport instruction (step S217). Specifically, when the third transport instruction having the third priority "low" is stored in the transport instruction information table 112, the allocation portion 124 determines to allocate the third transport instruction to a vacant transport vehicle. When a plurality of third transport instructions having the third priority "low" are stored in the transport instruction information table 112, the allocation portion 124 determines to allocate the third transport instruction having a larger value of priority to a vacant transport vehicle. When values of priority are the same, the allocation portion 124 determines to allocate the third transport instruction occurrence date and time of which are earlier to a vacant transport vehicle.

As described above, based on an index of the number of vacant transport vehicles gradually increasing and an index of priority gradually lowering, the larger the number of vacant transport vehicles is, the transport vehicle system 1 allows a lower-priority transport instruction to be allocated to a vacant transport vehicle. Therefore, occurrence of a state in which a higher-priority transport instruction cannot be allocated, can be suppressed while an index is flexibly changed in accordance with a scale of the system or upon request from users. In addition, reduction in operational rates of a device (processing device) that performs a processing on transported articles can be suppressed. Further, when a top-priority transport instruction having specific priority occurs, the transport vehicle system 1 allows the top-priority transport instruction to be allocated to a vacant transport vehicle regardless of the number of vacant transport vehicles. Therefore, transport operation desired to be executed immediately can be performed promptly. In the transport vehicle system1, the total number of vacant transport vehicles in a plurality of areas 9 are used, thus allocation of the transport instruction to a vacant transport vehicle existing in a plurality of areas 9 can be realized.

### [Second Embodiment]

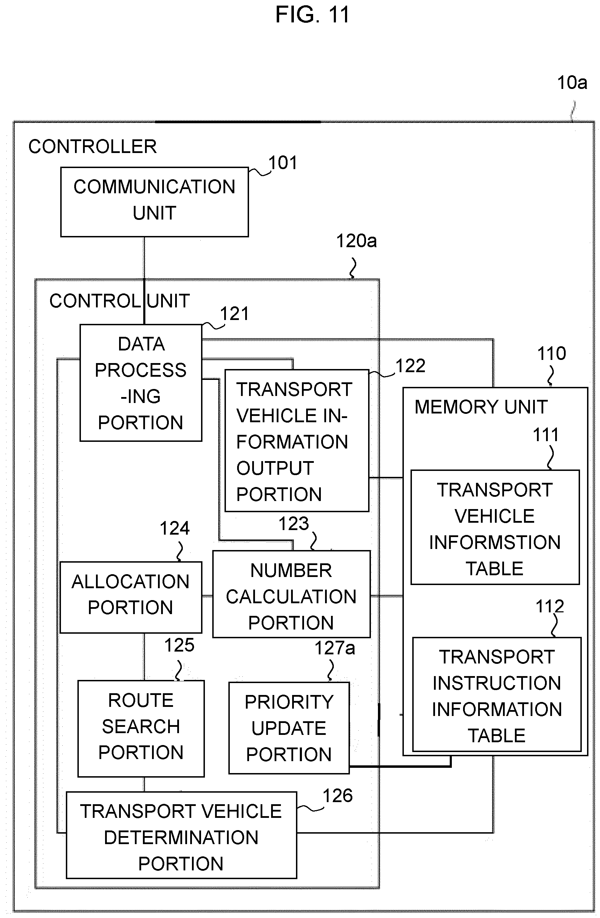

In a second embodiment, the same signs may be given to the same or equivalent configuration as that of above-described embodiment and the detailed description may be omitted or simplified. In the second embodiment, a configuration of the transport vehicle system 1 is the same as that of above-described embodiment. FIG. 11 is a block diagram illustrating a configuration example of controller (area controller) according to the second embodiment. As shown in FIG. 11, a controller 10a includes a communication unit 101, a memory unit 110 and a control unit 120a.

The memory unit 110 includes a transport vehicle information table 111 and a transport instruction information 112. Each information stored into the memory unit 110 is the same as that of above-described embodiment. In the second embodiment, the transport instruction information table 112 updates information on priority as described later.

The controller unit 120a includes a data processing portion 121, a transport vehicle information output portion 122, a number calculation portion 123, an allocation portion 124, a route search portion 125, a transport vehicle determination portion 126, and a priority update portion 127a. The priority update portion 127a raises priority of a transport instruction that has not been allocated to any transport vehicle 5 according to passage of time since the transport instruction occurred. The transport instruction information table 112 (see FIG. 5) stores information on transport instructions that have not been allocated to any transport vehicles 5. The priority update portion 127a accesses the transport instruction information table 112 and raises priority of a transport instruction that has not been allocated for a predetermined time based on the occurrence date and time of the transport instruction. For example, if a predetermined time has passed since occurrence date and time of a transport instruction having priority "30" , the priority update portion 127a raises the priority by "+5". The predetermined time may be set according to, for example, scale of the transport vehicle system 1 or capacity (processing time or the like) of a processing device and it can be optionally changed. Further, point by which priority is raised can be optionally changed.

Further, the priority update portion 127a raises priority stepwise according to passage of time. The priority raising frequency is not particularly limited. Thus, even if an initial priority is "low", it may be raised stepwise according to passage of time to "middle" or "high". The priority update portion 127a allows the priority to be raised up to an upper limit, which is set to be larger as the priority of a transport instruction upon occurrence of the transport instruction is higher. For example, an upper limit of priority "low" (e.g. less than 40) can be raised up to "70", an upper limit of priority "middle" (e.g. equal to or more than 40 and less than 60) can be raised up to "80", and an upper limit of priority "low" (e.g. equal to or more than 60) can be raised up to "90". The upper limit can be optionally changed.

Whereby, each part of the control unit 120a performs various processing described in above-described embodiment, using the transport instruction information table 112 in which priority is updated by the priority update portion 127a.

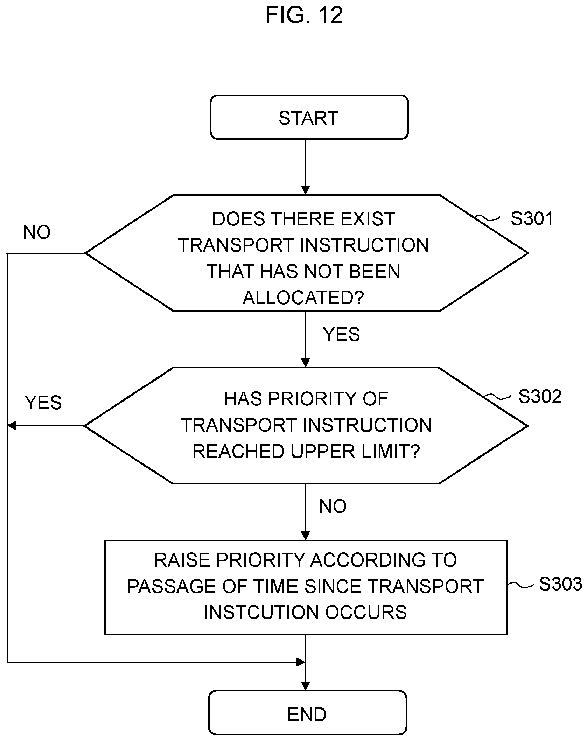

FIG. 12 is a flowchart illustrating an example of priority raising processing according to the second embodiment. As shown in FIG. 12, the priority update portion 127a determines whether or not there exists a transport instruction that has not been allocated (step S301). Specifically, the priority update portion 127a accesses the transport instruction information table 112 and determines whether or not information on a transport instruction is stored. When there exists no transport instruction that has not been allocated (step S301: NO), the priority update portion 127a completes the processing. Specifically, when no information on a transport instruction information table 112 is stored, the priority update portion 127a completes the processing.

On the other hand, when there exists a transport instruction that has not been allocated (step S301: YES), the priority update portion 127a determines whether or not priority of the transport instruction has reached the upper limit (step S302). Specifically, when information on a transport instruction is stored in the transport instruction information table 112, the priority update portion 127a determines whether or not priority of the transport instruction has reached the upper limit based on the priority while the information on the transport instruction is stored in the transport instruction information table 112.

When priority of the transport instruction has reached the upper limit (step S302: YES), the priority update portion 127a completes the processing. Specifically, when priority of the transport instruction has reached the upper limit according to priority while information on the transport instruction is stored in the transport instruction information table 112, the priority update portion 127a completes the processing. On the other hand, when the priority of the transport instruction has not reached the upper limit (step S302: NO), the priority update portion 127a raises the priority according to passage of time since the transport instruction occurred (step S303). Specifically, when priority of the transport instruction does not reach the upper limit according to priority while information on the transport instruction is stored in the transport instruction information table 112, the priority update portion 127a raises priority of the transport instruction that has not been allocated for a predetermined time according to occurrence date and time of the transport instruction.

As described above, priority of a transport instruction that has not been allocated to any transport vehicle 5 is raised according to passage of time since the transport instruction occurred, therefore, the transport vehicle system 1 can prevent a low-priority transport instruction from remaining without being allocated. Further, the higher the priority upon occurrence of a transport instruction is, the larger an upper limit is set to be. The priority is raised up to the upper limit stepwise, therefore, the transport vehicle system 1 can prevent initially-low-priority from being rapidly raised.

In above-described embodiment, an example of the controller 10 includes a computer system, for example. The controller 10 reads out a transport vehicle control program stored in the memory unit 110 and performs various processing in accordance with the transport vehicle control program which has been read out. The transport vehicle control program causes, for example, a computer to execute that: a first transport instruction having the first priority is allocated to a vacant transport vehicle when the first transport instruction occurs in a state in which the number of vacant transport vehicles is the first number, and that: a second transport instruction having the second priority lower than the first priority is not allocated to a vacant transport vehicle when the second transport instruction occurs in a state in which the number of vacant transport vehicles is the first number. The transport vehicle control program may be stored into a computer-readable storage media and provided.

As above described, embodiments were described. However, a technical range of the present invention is not limited to above-described embodiments. It is obvious for a person skilled in the art that various changes or improvements can be added to above-described embodiments. In addition, an embodiment to which changes or improvements are added is also included in the technical range of the present invention. One or more of requirements described in above-described embodiments may be omitted. Requirements described in above-described embodiments can be combined where appropriate. Each processing indicated in the present embodiments can be executed in any order unless output of previous processing is used for the following processing. Even if operations performed in above-described embodiments are explained using "first", "next", "then", or the like for convenience sake, the operations need not be performed in this order. As far as permitted by the applicable law, all the documents cited in above-described embodiments are incorporated herein by reference.

The technical range of the present invention is not limited to aspects described in above-described embodiments. One or more requirements described in above-described embodiments may be omitted. Further, requirements described in above-described embodiments can be combined where appropriate. As far as permitted by the applicable law, the contents of Japanese Patent Application No.2020-147385 and all the documents cited in above-mentioned embodiments are incorporated herein by reference.

### Reference Signs List

1 Transport vehicle system
3 Controller (upper level)
5 Transport vehicle
7 Track
9 Area
10 Controller (area)
101 Communication unit
110 Memory unit
111 Transport vehicle information table
112 Transport instruction information table
120 Control unit
121 Data processing portion
122 Transport vehicle information output portion
123 Number calculation portion
124 Allocation portion
125 Route search portion
126 Transport vehicle determination portion

## Claims

1. A transport vehicle system, comprising:
a plurality of transport vehicles; and
a controller configured to allocate transport instructions to the plurality of transport vehicles, wherein
the controller is configured
to allocate a first transport instruction having a first priority to a vacant transport vehicle when the first transport instruction occurs in a state where the number of vacant transport vehicles is a first number, and
not to allocate a second transport instruction having a second priority lower than the first priority to a vacant transport vehicle when the second transport instruction occurs in a state where the number of vacant transport vehicles is the first number.

2. The transport vehicle system according to claim 1, wherein
the controller is configured not to allocate the first transport instruction to a vacant transport vehicle when the first transport instruction having the first priority occurs in a state where the number of vacant transport vehicles is less than the first number.

3. The transport vehicle system according to claim 1 or 2, wherein
the controller is configured to allocate the second transport instruction to a vacant transport vehicle when the second transport instruction having the second priority occurs in a state where the number of vacant transport vehicles is a second number more than the first number.

4. The transport vehicle system according to any one of claims 1 to 3, wherein
the second priority is graded into a plurality of indices of priorities sequentially lowering,
the first number is graded into a plurality of indices of numbers of vacant travel vehicles sequentially increasing, and
the controller is configured to allow a lower-priority transport instruction to be allocated to a vacant transport vehicle as the number of vacant transport vehicles is larger.

5. The transport vehicle system according to any one of claims 1 to 4, wherein
the controller is configured to allow a top-priority transport instruction having a specific priority higher than the first priority to be allocated to the vacant transport vehicles regardless of the number of vacant transport vehicles when the top-priority transport instruction occurs.

6. The transport vehicle system according to any one of claims 1 to 5, wherein
the controller includes a plurality of area controllers, and
each of the plurality of area controllers is configured
to allocate a transport instruction to a transport vehicle inside a controlled area,
to allocate the first transport instruction to a vacant transport vehicle when the first transport instruction occurs in a state where a total number of vacant transport vehicles inside the controlled area and vacant transport vehicles outside the controlled area is the first number, and
not to allocate the second transport instruction to a vacant transport vehicle when the second transport instruction occurs in a state where the total number of vacant transport vehicles inside the controlled area and vacant transport vehicles outside the controlled area is the first number.

7. The transport vehicle system according to any one of claims 1 to 6, wherein
the controller is configured to raise a priority of a transport instruction which has not been allocated to any transport vehicle, according to passage of time since the transport instruction occurred.

8. The transport vehicle system according to claim 7, wherein
the controller is configured to raise the priority stepwise according to the passage of time.

9. The transport vehicle system according to claim 7 or 8, wherein
the controller is configured to allow the priority to be raised up to an upper limit, which is set to be larger as the priority upon occurrence of a transport instruction is higher.

10. A method of controlling transport vehicles in which transport instructions are allocated to a plurality of transport vehicles, the method comprising:
allocating a first transport instruction having a first priority to a vacant transport vehicle when the first transport instruction occurs in a state where the number of vacant transport vehicles is a first number; and
not allocating a second transport instruction having a second priority lower than the first priority to a vacant transport vehicle when the second transport instruction occurs in a state where the number of vacant transport vehicles is the first number.
